# EUROPÄISCHE PATENTSCHRIFT

(11) **EP 0 823 730 B1**
(45) Veröffentlichungstag und Bekanntmachung des Hinweises auf die Patenterteilung: **21.08.2002**
(21) Anmeldenummer: 97110594.5
(22) Anmeldetag: 27.06.1997
(51) Int. Cl.: H01L 21/768, H01L 21/316

(54) **Herstellverfahren für eine als Intermetalldielektrikum fungierende Isolatorschicht**
Method of making an isolation layer serving as intermetal dielectric
Méthode de fabrication d'une couche isolante servant pour une diélectrique intermétallique

(30) Priorität: 06.08.1996 DE 19631743
(43) Veröffentlichungstag der Anmeldung: 11.02.1998
(73) Patentinhaber: Infineon Technologies AG, 81669 München (DE); Fraunhofer-Gesellschaft zur Förderung der angewandten Forschung e.V., 80636 München (DE)
(72) Erfinder: Gabric, Zvonimir, 85604 Zorneding (DE); Spindler, Oswald, Dr., 85591 Vaterstetten (DE); Grassl, Thomas, 85354 Freising (DE)
(74) Vertreter: Kindermann, Peter

(56) Entgegenhaltungen:
- EP-A- 0 537 001
- US-A- 5 399 389
- US-A- 5 420 075
- US-A- 5 444 023
- US-A- 5 518 959

## Beschreibung

Herstellverfahren für eine als Intermetalldielektrikum fungierende Isolatorschicht

Die Erfindung bezieht sich auf ein Herstellverfahren für eine als Intermetalldielektrikum (IMD) fungierende Isolatorschicht auf einem Substrat.

Bei der Erzeugung höchstintegrierter Schaltkreise treten innerhalb der Leiterbahnenebenen starke Höhenunterschiede auf. Diese extremen Schwankungen in den Topographien führen zu enormen Schwierigkeiten bei Fotolithographieprozessen, da ein direkter Zusammenhang zwischen Auflösung und Tiefenschärfe besteht.

Ferner wird es bei zunehmender Integrationsdichte aufgrund der abnehmenden Leiterbahnenabstände und der zunehmenden Seitenverhältnisse zwischen den Leiterbahnen immer schwieriger, diese Spalte mit Intermetalldielektrika lunkerfrei aufzufüllen.

Aus der EP-A-0 537 001 ist ein Verfahren zum Herstellen und Planarisieren eines Intermetalldielektrikums auf einem Halbleiterbaustein bekannt. Dabei wird auf die Substratoberfläche eine erste Isolationsschicht aufgebracht. Diese erste Isolationsschicht wird mit einer Metallschicht bedeckt, die dann über einen Fotoschritt zu Metall-Leiterbahnen strukturiert wird. Die Metall-Leiterbahnen werden dann auf ihren Oberflächen mit einer zweiten Isolationsschicht bedeckt und auf das so strukturierte Substrat wird schließlich eine dritte Isolationsschicht über ein ozonaktiviertes CVD-Verfahren abgeschieden. Die erste und die zweite Isolationsschicht werden dabei so gewählt, daß die Aufwuchsrate der dritten Isolationsschicht auf der ersten Isolationsschicht größer ist als auf der zweiten Isolationsschicht. Als nachteilig an diesem Verfahren hat sich herausgestellt, daß dabei die Seitenflanken der Metall-Leiterbahnen nicht mit einer leitenden Barriereschicht bedeckt sind. Diese Metall-Leiterbahnen-Seitenflanken sind zumeist oxidiert, d.h. sie sind mit Metalloxid bedeckt. Die Aufwuchsrate auf diesen Metalloxidflanken entspricht aber der Aufwuchsrate auf der ersten Isolationsschicht, die in der Regel aus Siliziumoxid besteht. Dadurch kommt es bei dieser selektiven Abscheidung der dritten Isolationsschicht zu Ausbuchtungen oberhalb der Oberkanten der Metall-Leiterbahnen. Diese Ausbuchtungen werden "Ohren" genannt. Diese "Ohrenbildung" ist selbstverständlich unerwünscht und muß über ein CMP-Verfahren (Chemical Mechanical Polishing) beseitigt werden.

US-A-5 444 023 und US-A-5 420 075 offenbaren auch ein Verfahren zur Herstellung eines Intermetalldielektrikums.

Aufgabe der vorliegenden Erfindung ist es daher, ein Herstellverfahren für eine als Intermetalldielektrikum (IMD) fungierende Isolationsschicht auf einem Halbleitersubstrat anzugeben, bei der es nicht oder nur in geringem Maße zu der unerwünschten "Ohrenbildung" kommt.

Dieses Verfahren ist gekennzeichnet durch folgende Schritte:
a) Die Substratoberfläche wird mit einer ersten Isolationsschicht bedeckt,
b) die erste Isolationsschicht wird mit einer Metallschicht bedeckt,
c) in die Metallschicht werden über einen Fotoschritt Metall-Leiterbahnen strukturiert,
d) die Metall-Leiterbahnen werden auf ihren Oberflächen und auf ihren Seitenflanken mit einer zweiten Isolationsschicht bedeckt,
e) die zwischen den Metall-Leiterbahnen auf der ersten Isolationsschicht befindliche zweite Isolationsschicht wird entfernt,
f) auf das so strukturierte Substrat wird eine dritte Isolationsschicht in einem ozonaktivierten CVD-Verfahren abgeschieden, wobei die erste und die zweite Isolationsschicht so gewählt werden, daß die Aufwuchsrate der dritten Isolationsschicht auf der ersten Isolationsschicht größer ist als auf der zweiten Isolationsschicht.

Typischerweise wird für eine Feinbearbeitung der Substratoberfläche danach die dritte Isolationsschicht über ein CMP-Verfahren (Chemical Mechanical Polishing) planarisiert.

Als erste Isolationsschicht kommen Phophorsilikatglas, Borphosphorsilikatglas oder undotiertes Silikatglas in Betracht, die über ozonaktivierte CVD-Verfahren abgeschieden werden können.

Als zweite Isolationsschicht wird typischerweise Titannitrid abgeschieden, wobei dies durch ein CVD-Verfahren oder ein PECVD-Verfahren erfolgen kann.

Als Ausgangssubstanzen für die dritte Isolationsschicht wird vorzugsweise TEOS (Tetraethylorthosilikat) oder OMTC (Octametylzyklotetrasiloxan) oder HMDS (Hexametylisiloxan) verwendet.

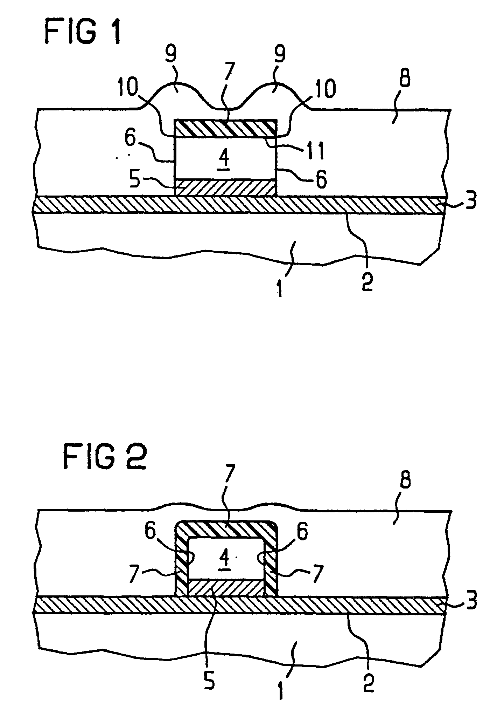

Die Erfindung wird anhand eines Ausführungsbeispiels in Verbindung mit den Figuren 1 und 2 näher erläutert. Die Figur 1 zeigt dabei ein abgeschiedenes Intermetalldielektrikum gemäß dem Stand der Technik und die Figur 2 ein abgeschiedenes Intermetalldielektrikum gemäß der vorliegenden Erfindung.

In Figur 1 ist ein Siliziumsubstrat gezeigt und mit 1 bezeichnet. Auf diesem Siliziumsubstrat 1 ist auf der Substratoberfläche 2 eine erste Isolationsschicht 3 aus Siliziumoxid aufgebracht. Diese erste Isolationsschicht 3 ist mit einer Metall-Leiterbahn 4 aus Aluminium bedeckt, wobei zwischen der Aluminiumleiterbahn 4 und der ersten Isolationsschicht 3 eine Titan/Titannitridschicht 5 eingebracht ist. Diese Titan/Titannitridschicht 5 dient als Diffusionsbarriere und als Haftvermittler zwischen der Aluminiumleiterbahn 4 und der darunterliegenden Isolationsschicht 3. Auf der Oberfläche 11 der Metalleiterbahn 4 ist eine zweite Isolationsschicht 7 aus Titannitrid aufgebracht.

Die Seitenflanken 6 der Aluminiumleiterbahn 4 sind mit keiner speziellen Isolationsschicht versehen. Die Seitenflanken 6 aus Aluminiumleiterbahn 4 sind zumeist mit Al₂O₃ bedeckt, d.h. an ihrer Oberfläche oxidiert.

Auf die Aluminiumleiterbahn 4 wird über ein ozonaktiviertes CVD-Verfahren eine dritte Isolationsschicht 8 abgeschieden. Als Ausgangssubstanz für diese dritte Isolationsschicht 8 dient hier Tetraethylorthosilicat (TEOS).

Die Aufwuchsrate dieser dritten Isolationsschicht 8 auf der ersten Isolationsschicht 3 ist wesentlich höher als auf der Titannitridschicht 7. Da aber die Seitenflanken der Aluminiumleiterbahn 4 in erster Näherung aus Aluminiumoxid bestehen, ist dort die Aufwuchsrate mehr oder weniger gleich groß wie die Aufwuchsrate auf der ersten Isolationsschicht 3, so daß es zu der Ausbildung von den ohrenartigen Ausbuchtungen 9 oberhalb der Oberkanten 10 der Aluminiumleiterbahn 4 kommt.

Wie in Figur 2 zu sehen ist, ist dort die Aluminiumleiterbahn 4 an ihren Seitenflanken 6 ebenfalls mit der zweiten Isolationsschicht 7 aus Titannitrid bedeckt. Die Aluminiumleiterbahn 4 ist demnach hier vollständig mit Titannitrid eingekapselt, so daß das über das ozonaktivierte CVD-Verfahren abgeschiedene Siliziumoxid 8 an den Seitenflanken eine ebenso geringe Aufwuchsrate erzielt wie auf der Oberfläche der mit Titannitrid bedeckten Aluminiumleiterbahn 4. Dadurch kommt es nicht zu der Ausbildung der ohrenartigen Ausbuchtungen oberhalb der Oberkanten der Aluminiumleiterbahn.

Durch diese Einkapselung der Aluminiumleiterbahn 4 mit einer Titannitridschicht 7 wird eine so niedrige Aufwuchsrate an den Seitenflanken 6 erzielt, daß Leiterbahnabstände bis herunter zu 0,2 µm und Seitenverhältnisse (Aspektverhältnisse) bis zu 6 lunkerfrei aufgefüllt werden können.

Das ozonaktivierte CVD-Verfahren, das zur Abscheidung der dritten Isolationsschicht 8 verwendet wird, findet unter nahezu Atmosphärendruck und einem vergleichsweise hohen Ozonfluß bei hoher Ozonkonzentration statt.

## Patentansprüche

1. Herstellverfahren für eine als Intermetalldielektrikum (IMD) fungierende Isolationsschicht auf einem Substrat mit folgenden Schritten:
a) Die Substratoberfläche (2) wird mit einer ersten Isolationsschicht (3) bedeckt,
b) die erste Isolationsschicht (3) wird mit einer Metallschicht bedeckt,
c) in die Metallschicht werden über einen Fotoschritt Metall-Leiterbahnen (4) strukturiert,
d) die Metall-Leiterbahnen (4) werden auf ihren Oberflächen (11) und auf ihren Seitenflanken (6) mit einer zweiten Isolationsschicht (7) bedeckt,
e) die zwischen den Metall-Leiterbahnen (4) auf der ersten Isolationsschicht (3) befindliche zweite Isolationsschicht (7) wird entfernt,
f) auf das so strukturierte Substrat wird eine dritte Isolationsschicht (8) über ein ozonaktiviertes CVD-Verfahren abgeschieden, wobei die erste Isolationsschicht (3) und die zweite Isolationsschicht (7) so gewählt werden, daß die Aufwuchsrate der dritten Isolationsschicht (8) auf der ersten Isolationsschicht (3) größer ist als auf der zweiten Isolationsschicht (7).

2. Herstellverfahren nach Anspruch 1,
**dadurch gekennzeichnet, daß** danach die dritte Isolationsschicht (8) über ein CMP-Verfahren (Chemical Mechanical Polishing) planarisiert wird.

3. Herstellverfahren nach Anspruch 1 oder 2,
**dadurch gekennzeichnet, daß** als erste Isolationsschicht (3) Phosphorsilikatglas oder Borphosphorsilikatglas oder undotiertes Silikatglas abgeschieden werden.

4. Herstellverfahren nach Anspruch 3,
**dadurch gekennzeichnet, daß** die erste Isolationsschicht (3) über ein ozonaktiviertes CVD-Verfahren abgeschieden wird.

5. Herstellverfahren nach Anspruch 1 oder 2,
**dadurch gekennzeichnet, daß** als zweite Isolationsschicht (7) Titannitrid abgeschieden wird.

6. Herstellverfahren nach Anspruch 5,
**dadurch gekennzeichnet, daß** die Titannitridschicht (7) durch ein CVD-Verfahren oder ein PECVD-Verfahren abgeschieden wird.

7. Herstellverfahren nach Anspruch 1 oder 2,
**dadurch gekennzeichnet, daß** als Ausgangssubstanzen für die dritte Isolationsschicht (8) TEOS (Tetraethylorthosilicat) oder OMTC (Octamethylzyklotetrasilocsan) oder HMDS (Hexamethyldisilocsan) ausgewählt wird.

8. Herstellverfahren nach einem der Ansprüche 1 bis 7,
**dadurch gekennzeichnet, daß** die Metall-Leiterbahnen (4) aus Aluminium bestehen.

## Claims

1. Fabrication method for an insulation layer, which functions as an intermetal dielectric (IMD), on a substrate, comprising the following steps:
a) the substrate surface (2) is covered with a first insulation layer (3),
b) the first insulation layer (3) is covered with a metal layer,
c) metal interconnects (4) are patterned into the metal layer using a photographic step,
d) the metal interconnects (4) are covered with a second insulation layer (7) on their surfaces (11) and on their side flanks (6),
e) the second insulation layer (7) located between the metal interconnects (4) on the first insulation layer (3) is removed,
f) a third insulation layer (8) is deposited onto the substrate which has been patterned in this way using an ozone-activated CVD process, the first insulation layer (3) and the second insulation layer (7) being selected in such a way that the growth rate of the third insulation layer (8) is greater on the first insulation layer (3) than on the second insulation layer (7).

2. Fabrication method according to Claim 1, **characterized in that** the third insulation layer (8) is then planarized using a CMP (chemical mechanical polishing) process.

3. Fabrication method according to Claim 1 or 2, **characterized in that** phosphosilicate glass or borophosphosilicate glass or undoped silicate glass is deposited as first insulation layer (3).

4. Fabrication method according to Claim 3, **characterized in that** the first insulation layer (3) is deposited using an ozone-activated CVD process.

5. Fabrication method according to Claim 1 or 2, **characterized in that** titanium nitride is deposited as the second insulation layer (7).

6. Fabrication method according to Claim 5, **characterized in that** the titanium nitride layer (7) is deposited by a CVD process or a PECVD process.

7. Fabrication method according to Claim 1 or 2, **characterized in that** TEOS (tetraethyl orthosilicate) or OMTC (octamethylcyclotetrasiloxane) or HMDS (hexamethyldisiloxane) is selected as starting substances for the third insulation layer (8).

8. Fabrication method according to one of Claims 1 to 7, **characterized in that** the metal interconnects (4) consist of aluminium.

## Revendications

1. Procédé de production d'une couche isolante servant de diélectrique intermétallique (DIM) sur un substrat, comportant les étapes suivantes :
a) on revêt la surface (2) du substrat d'une première couche (3) isolante,
b) on revêt la première couche (3) isolante d'une couche métallique,
c) on structure dans la couche métallique les pistes (4) conductrices métalliques par un stade de photosensibilité,
d) on revêt les pistes (4) conductrices métalliques sur leurs surfaces (11) et sur leurs flancs (6) latéraux d'une deuxième couche (7) isolante,
e) on élimine la deuxième couche (7) isolante se trouvant entre les pistes (4) conductrices métalliques sur la première couche (3) isolante,
f) sur le substrat ainsi structuré, on dépose une troisième couche (8) isolante par un procédé CVD activé à l'ozone, la première couche (3) isolante et la deuxième couche (7) isolante étant choisies de manière que la vitesse de croissance de la troisième couche (8) isolante soit plus grande sur la première couche (3) isolante que sur la deuxième couche (7) isolante.

2. Procédé de production selon la revendication 1, **caractérisé en ce qu'**après, on planarise la troisième couche (3) isolante par un procédé CMP (Chemical Mechanical Polishing).

3. Procédé de production selon la revendication 1 ou 2, **caractérisé en ce que** l'on dépose comme première couche (3) isolante du verre au phosphosilicate ou du verre au borophosphosilicate ou du verre de silicate non dopé.

4. Procédé de production selon la revendication 3, **caractérisé en ce que** l'on dépose la première couche (3) isolante par un procédé CVD activé à l'ozone.

5. Procédé de production selon la revendication 1 ou 2, **caractérisé en ce que** l'on dépose du nitrure de titane comme deuxième couche (7) isolante.

6. Procédé de production selon la revendication 5, **caractérisé en ce que** l'on dépose la couche (7) en nitrure de titane par un procédé CVD ou par un procédé PECVD.

7. Procédé de production selon la revendication 1 ou 2, **caractérisé en ce que** l'on sélectionne, comme substance de départ pour la troisième couche (8) isolante, du TEOS (orthosilicate de tétraéthyle) ou de l'OMTC (octaméthylcyclotétrasiloxane) ou de l'HMDS (hexaméthyldisiloxane)

8. Procédé selon la revendication 1 à 7, **caractérisé en ce que** les pistes (4) conductrices métalliques sont en aluminium.
